(19) **Europäisches Patentamt**

**European Patent Office**

**Office européen des brevets**

(11) Veröffentlichungsnummer: **0 346 605**
**A2**

(12) **EUROPÄISCHE PATENTANMELDUNG**

(21) Anmeldenummer: **89107985.7**

(22) Anmeldetag: **03.05.89**

(51) Int. Cl.⁴: **H03M 1/18 , H03M 1/70**

(30) Priorität: **14.06.88 DE 3820144**

(43) Veröffentlichungstag der Anmeldung:
**20.12.89 Patentblatt 89/51**

(84) Benannte Vertragsstaaten:
**AT CH LI NL**

(71) Anmelder: **ANT Nachrichtentechnik GmbH**
**Gerberstrasse 33**
**D-7150 Backnang(DE)**

(72) Erfinder: **Göckler, Heinz, Dipl.-Ing.**
**Elbinger Strasse 52**
**D-7150 Backnang(DE)**
Erfinder: **Baudisch, Werner, Dipl.-Ing.**
**Am Söhlberg 3**
**D-3341 Denkte 1(DE)**
Erfinder: **Masslich, Roland, Dipl.-Ing.**
**Heinrichstrasse 37**
**D-3300 Braunschweig(DE)**
Erfinder: **Wermuth, Jürgen, Ing. grad.**
**Drosselweg 1**
**D-3150 Peine(DE)**
Erfinder: **Langner, Werner, Ing. grad.**
**Ringstrasse 16**
**D-3341 Klein Denkte(DE)**
Erfinder: **Hauk, Waldemar, Dr. Ing.**
**Häfnersweg 104**
**D-7150 Backnang(DE)**
Erfinder: **Gödecke, Friedrich-Wilhelm,**
**Dipl.-Ing.**
**Jasperallee 37**
**D-3300 Branschweig(DE)**

(54) **Hochauflösender Analog/Digital- bzw. Digital/Analog-Umsetzer.**

(57) Die Erfindung betrifft einen hochauflösenden A/D-Umsetzer, dem ein Verstärker mit in $L+1$-Stufen programmierter Verstärkung vorgeschaltet ist und dem durch Auswahl der Verstärkungsstufe das ohne Übersteuerung größtmögliche Signal zur Umsetzung zugeführt wird. Aufgabe ist es, eine höhere Auflösung zu erreichen, als diejenige, die an sich aufgrund der Bitanzahl gegeben ist. Das Ziel wird erreicht, indem das analoge Eingangssignal um einen bestimmten Faktor $s_i$ verstärkt und anschließend in ein digitales Wort umgesetzt wird; danach wird dieses umgesetzte Wort multipliziert mit dem Kehrwert $1/s_i$ des Faktors, wobei die Wortlänge vergrößert wird. Anwendungsgebiet ist die Audiosignalverarbeitung in Tonstudios.

# FIG. 1

## Hochauflösender Analog/Digital- bzw. Digital/Analog-Umsetzer

Die Erfindung betrifft ein Verfahren zur hochauflösenden Analog/Digital-Umsetzung gemäß Anspruch 1 und hochauflösende Analog/Digital-Umsetzer bzw. Digital/Analog-Umsetzer gemäß Anspruch 3 bzw. 14. Bei der digitalen Verarbeitung beispielsweise von Audiosignalen werden große Signalwortlängen z. B. 24 oder gar 32 Bit, verwendet, um einen hohen Signal-Geräuschabstand zu erhalten. In vielen Fällen werden solche Anlagen von analogen Signalen gespeist, die vor der digitalen Bearbeitung oder Abspeicherung von der analogen (zeitkontinuierlichen) Darstellung in die zeitdiskrete bzw. digitale Darstellung umgesetzt werden müssen. Bei den hier zu verwendenden Abtastfrequenzen im Bereich von etwa 50 KHz stehen heute preisgünstige Festkomma-A/D-Umsetzer in integrierter Form mit einer Auflösung von 16 Bit zur Verfügung, beispielsweise die Konverter vom Typ Hibit der Firma Yamaha. Darüberhinaus sind auch einzelne sehr teure Exemplare mit bis zu 18 Bit verfügbar (ADU bzw. DAU) angekündigt.

Der vorliegenden Erfindung lag die Aufgabe zugrunde, einen hochauflösenden A/D-Umsetzer bzw. D/A-Umsetzer anzugeben, der ohne großen Mehraufwand eine noch höhere Auflösung bietet als diejenige, die an sich aufgrund der Bitanzahl gegeben ist.

Die Aufgabe wurde gelöst entsprechend den kennzeichnenden Merkmalen der Ansprüche 1, 3 bzw. 14.

Der vorliegende erfindungsgemäße A/D-Umsetzer bzw. D/A-Umsetzer weist eine höhere Auflösung auf, als man sie bei einer bestimmten Wortlänge erhalten würde, er weist nämlich eine Auflösung auf, die einer um m Bit größeren Wortlänge entspricht. Der Aufwand hierfür ist relativ niedrig. Die Erfindung geht aus von der Idee, daß ein A/D-Umsetzer bei Vollaussteuerung eine geringere Auflösung als bei abnehmender Aussteuerung aufweisen kann, d. h. daß die Auflösung bei kleinsten Aussteuerungspegeln am höchsten ist beispielsweise 20 Bit und mit zunehmenden Pegeln kleiner werden kann. Diese Eigenschaft rührt daher, daß auch noch leise Passagen, beispielsweise eines Musikstücks, mit einem hohen Signalgeräuschabstand in die digitale Darstellung zu überführen sind. Dagegen genügt bei lauten Passagen, also Signalen mit großen Amplituden eine Auflösung, d. h. Genauigkeit der Darstellung von beispielsweise 16 Bit.

Es folgt nun die Beschreibung der Erfindung anhand der Figuren. Die Grundstruktur der erfindungsgemäßen Lösung für einen hochauflösenden A/D-Umsetzer ist in Figur 1 wiedergegeben. Weitere Ausgestaltungen verschiedener Details sind den Figuren 2 bis 7 zu entnehmen. In Figur 8 und 9 ist ein Beispiel für einen D/A-Umsetzer gezeichnet.

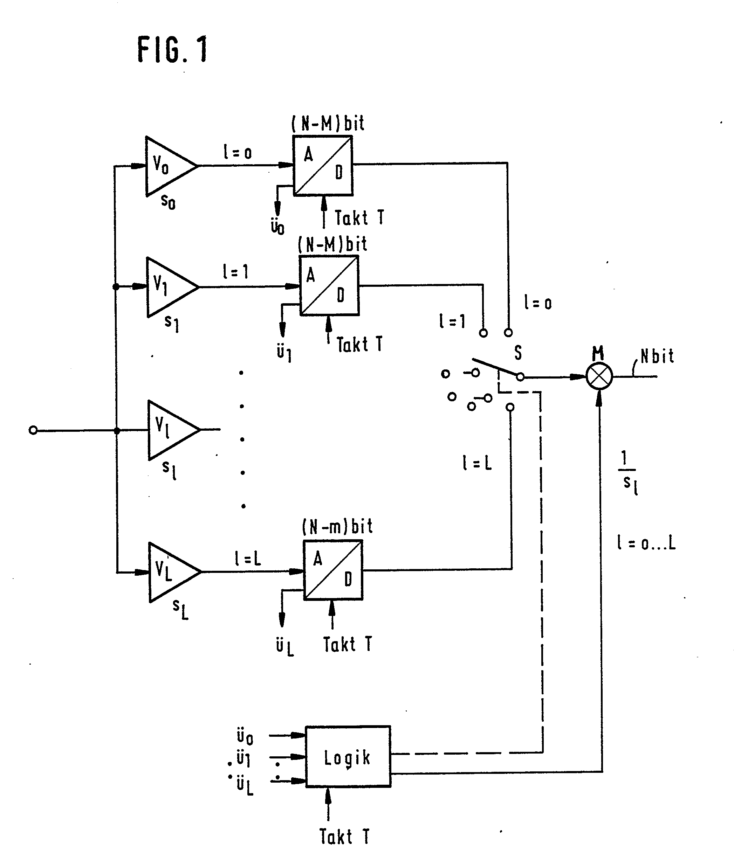

In Figur 1 sind $L+1$ parallele im wesentlichen gleiche Zweige vorgesehen, bestehend aus der Kaskadenschaltung jeweils eines Verstärkers $V_l$ für $l=0$ bis $L$ und eines A/D-Umsetzers mit der Auflösung $(N-m)$ Bit, wobei alle $L+1$ A/D-Umsetzer identisch sein können. Die Verstärker, denen jeweils das analoge Eingangssignal zugeführt wird, weisen jeweils eine zweigabhängige Verstärkung (Skalierung) $s_l$ auf. Jeweils ein A/D-Umsetzerausgang kann mittels eines Auswahlschalters S, eine digitale Torschaltung, auf eine Leitung geschaltet werden, die einen digitalen Multiplizierer speist, der den jeweiligen digitalisierten Abtastwert mit dem Kehrwert $1/s_l$ der Verstärkung des Verstärkers $V_l$ des gerade durchgeschalteten Zweigs $l$ multipliziert. Dieser Kehrwert weist beispielsweise in diesem Fall die Wortlänge m auf, so daß das Multipliziererausgangssignal die um m vergrößerte Wortlänge N Bit aufweist. Die Stellung des Auswahlschalters S wird durch eine digitale Logikschaltung festgelegt, ebenso der jeweilige zugehörige Rückskalierungsfaktor $1/s_l$. Die Logikschaltung wird gespeist durch die logischen Größen $\ddot{U}_l$ für $l = 0 \dots L$, welche anzeigen, welche der $L+1$ A/D-Umsetzer gerade übersteuert sind bzw. wie groß die Übersteuerungsreserve ist. Grundregel ist, daß die Logikschaltung von all den Zweigen mit nichtübersteuerten A/D-Umsetzern stets denjenigen durchschaltet, bei dem der A/D-Umsetzer die geringste Übersteuerungsreserve aufweist, d. h. denjenigen A/D-Umsetzer, der gerade am weitesten ausgesteuert ist, ohne übersteuert zu sein. Ergänzend sei bemerkt, daß sich die Stellung des Schalters S im Takt $T = 1/f_A$ mit der Abtastfrequenz $f_A$ ändern kann, weshalb die Logikschaltung ebenfalls mit dem Takt T ebenso wie die A/D-Umsetzer getaktet wird. Unter der Voraussetzung, daß die einzelnen Verstärkungen $s_0 < s_1 < s_2 < \dots < s_l < \dots s_L$ sind, genügt es, in der Logikschaltung beginnend mit $l=L$ über L-1, L-2 usw. in monoton fallendender Reihenfolge die Signale $\ddot{u}_l$ auf Übersteuerung zu prüfen. Durchgeschaltet wird dann der Zweig l, bei dem zum ersten Mal $\ddot{u}_l$ in diesem Durchgang keine Übersteuerung angezeigt hat. Tritt dieses Ereignis ein, so kann auch die Überprüfung der restlichen Übersteuerungssignale $\ddot{u}_{l-1} \dots \ddot{u}_0$ verzichtet werden.

Die Erhöhung der Auflösung bei Aussteuerungen $\leq s_0/s_L$ beträgt $m = \mathrm{ld}\, s_L/s_0$ Bit
mit ld = Logarithmus dualis.
Ist beispielsweise $L=3$, so ergeben sich die einzelnen Verstärkungen zu $s_0 = 1$, $s_1 = 3/2$, $s_2 = 9/4$ und $s_3 = 27/8$. Mit $s_0/s_L = 8/27$ wird $m = \mathrm{ld}\, 27/8$ ungefähr gleich 1,75 Bit. Staffelt man die Verstärkungen nach folgender Gleichung
sl = $2^i \cdot 2^l$ mit i = konstant,
so wird die Erhöhung der Auflösung m = L, weil m = $\text{ld} s_L/s_0 = \text{ld} 2^L = L \bullet s_0/s_L$ wird damit zu $2^{-L}$. Die Auflösung der A/D-Umsetzeranordnung gemäß Figur 1 erhöht sich dann genau um 1 Bit, wenn der Eingangswert auf die Hälfte abgesunken ist. Weiterhin vereinfacht sich die Rückskalierung im digitalen Multiplizierer mit $1/s_l = 2^{-i} \cdot 2^{-l}$ zu einer reinen Schiebeoperation, die dann aufgrund der Wortbreite von mindestens N Bit keinen zusätzlichen Quantisierungsfehler verursacht.

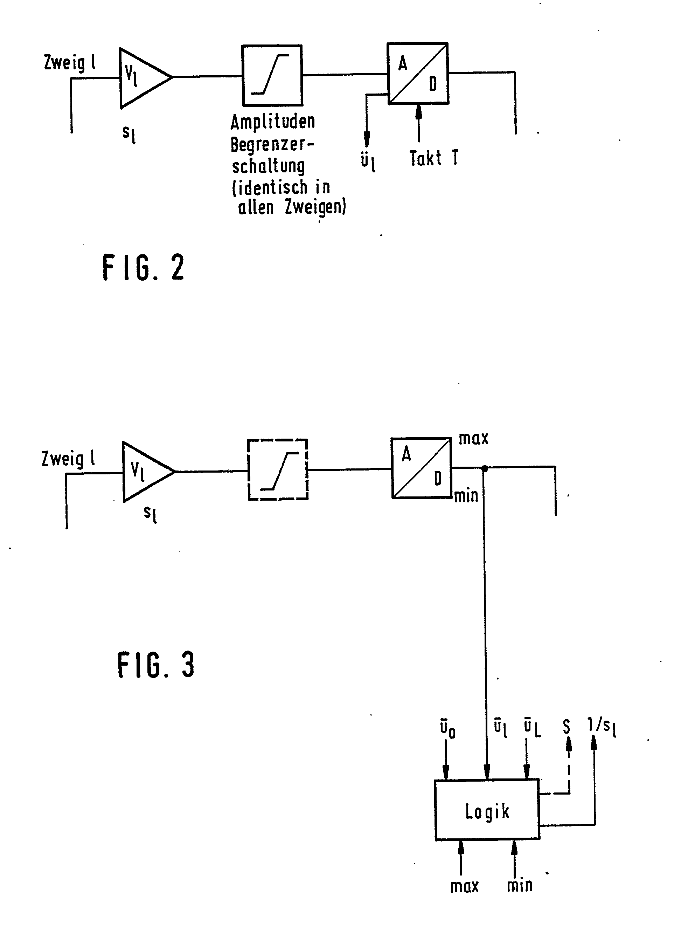

Zur Vermeidung von zu hohen oder gar schädigenden Übersteuerungen ist es vorteilhaft, den Eingangswert der L + 1 A/D-Umsetzer durch eine Amplitudenbegrenzerschaltung zu begrenzen. Die Figur 2 zeigt einen solchen mit einem Amplitudenbegrenzer ausgerüsteten Zweig. Sofern alle A/D-Umsetzer identisch sind, kommen in allen L + 1-Zweigen ebenfalls identische Begrenzer zum Einsatz. Die Sättigungsschwelle der Begrenzerschaltungen kann knapp über oder unter der Aussteuerungsgrenze des A/D-Umsetzers liegen oder mit dieser übereinstimmen. In den letzteren beiden Fällen können die Steuersignale $\ddot{u}_l$ für l = 0 ... L auch von der Amplitudenbegrenzerschaltung anstelle von den A/D-Umsetzern abgenommen werden. Gemäß einer anderen Variante können die Steuersignale $\ddot{u}_l$ auch aus den Ausgangssignalen der A/D-Umsetzer und zwar mit oder ohne vorgeschaltetem Amplitudenbegrenzer abgeleitet werden, indem in der Logikschaltung die digitalen Signale in Relation zum maximalen bzw. minimalen Ausgangswert der A/D-Umsetzer gesetzt werden. Dies ist in Figur 3 angedeutet.

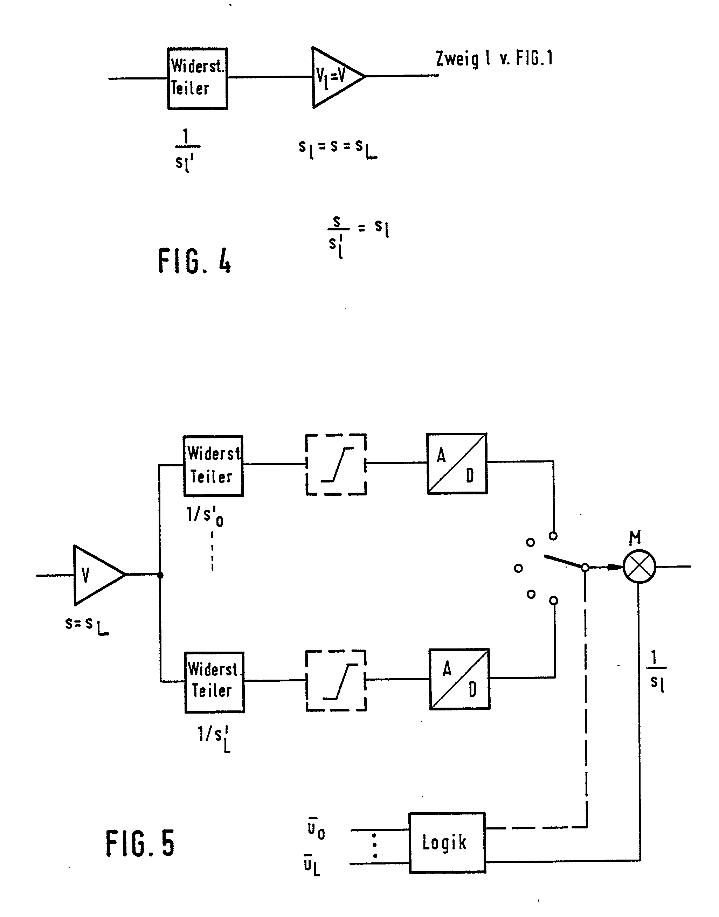

Eine Vereinfachung für die Herstellung und den Abgleich ergibt sich, wenn alle verwendeten Verstärker $V_l$ identisch sind. Dies ist möglich durch eine Anordnung gemäß Figur 4, die einen Zweig stellvertretend zeigt. Hier wird den Verstärkern $V_l$, deren Verstärkung also in allen Zweigen zu $s_l = s_L$ gewählt wird, ein Widerstandteiler vorgeschaltet, welche die Abschwächungsfaktoren $1/s_l'$ aufweisen mit l = 0 ... bis L. Es gilt die Bedingung $s_L/s_l' = s_l$ einzuhalten.

Vertauscht man die Reihenfolge von Widerstandteiler und Verstärker nach Figur 4, so kann man die L + 1-Verstärker vor dem Verzweigungspunkt am Eingang von Figur 1 ziehen; gemäß Figur 5 benötigt man dann nur noch einen einzigen Verstärker.

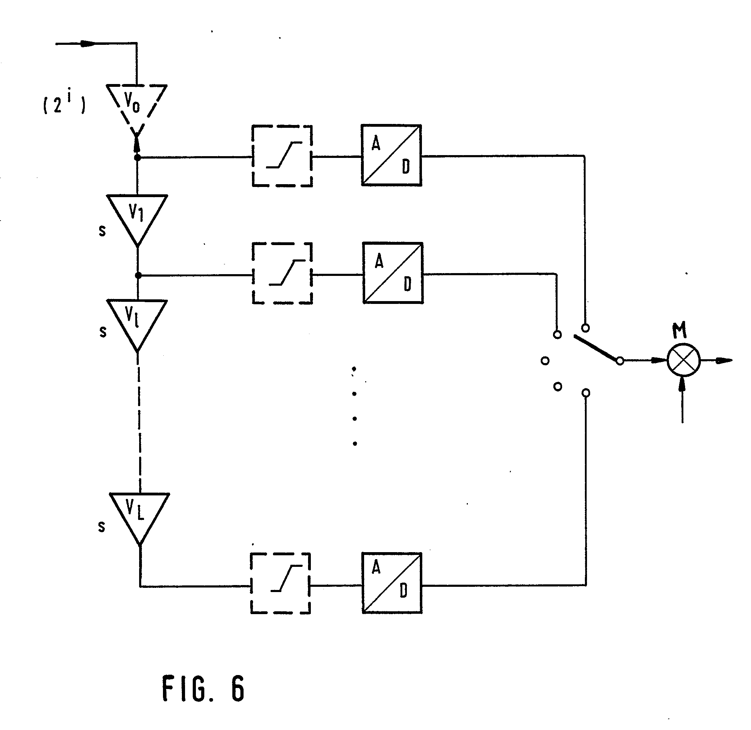

Eine weitere Variante mit identischen Verstärkern der Verstärkung $(s = s_L/s_0)^{1/L}$ ist in Figur 6 dargestellt. Macht man hier ebenfalls $s_l = 2^i \cdot 2^l$, so ergibt sich der Vorteil einer einfachen Realisierung. Die Figur 6 zeigt links eine Verstärkerkette, der am Eingangsverstärker das Eingangssignal zugeführt wird und die nach jedem Verstärker die Abzweigpunkte zu den einzelnen Zweigen mit dem A/D-Umsetzer aufweisen.

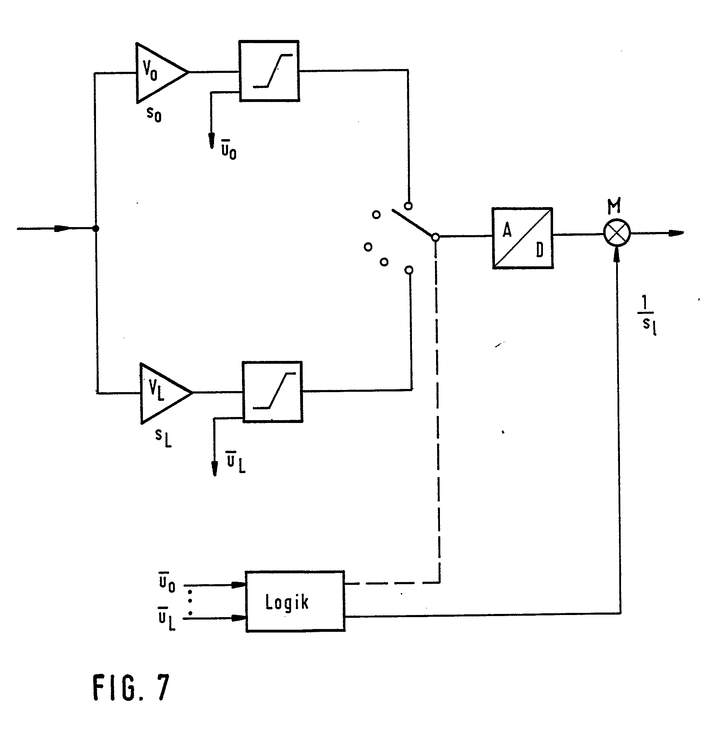

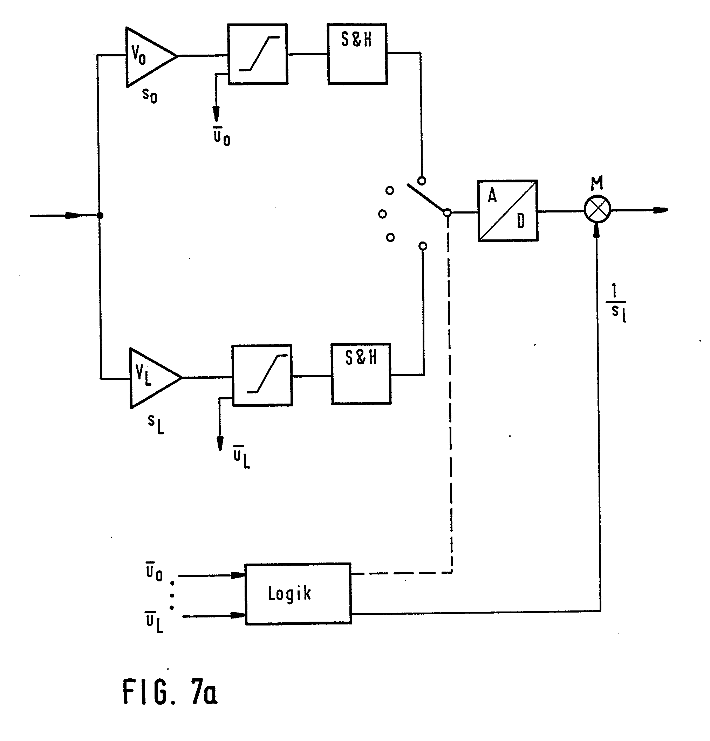

Sofern identische A/D-Umsetzer mit vorgeschalteten Amplitudenbegrenzern, die die Steuersignale $\ddot{u}_l$ abgeben, vorgesehen sind, so kann der Auswahlschalter S auch vor die A/D-Umsetzer gesetzt werden, und dann ist nur noch ein einziger A/D-Umsetzer erforderlich. Diese Anordnung ist in Figur 7 gezeigt. In diesem Fall ist der Auswahlschalter S ein analoger Schalter.

Wegen der endlichen und zum Teil relativ langen Einschwingzeiten der A/D-Umsetzer, lange Einschwingzeiten insbesondere bei preisgünstigen integrierten A/D-Umsetzern, ist in Systemen ohne Überabtastung eine Variante nach Figur 7a vorzusehen, die genau die gleiche Struktur wie die der Figur 7 aufweist, wobei aber in den einzelnen Zweigen zwischen Amplitudenbegrenzer und Auswahlschalter jeweils ein Sample- und Hold-Verstärker eingefügt sind.

Alle Anordnungen gemäß Figur 1 bis Figur 7a können als Anordnungen zur D/A-Umsetzung verwendet werden, wenn die Signalflußrichtungen und die Bauelemente umgekehrt, die A/D-Umsetzer durch D/A-Umsetzer ersetzt und für die Skalierungsfaktoren jeweils die Reziprokwerte eingesetzt werden.

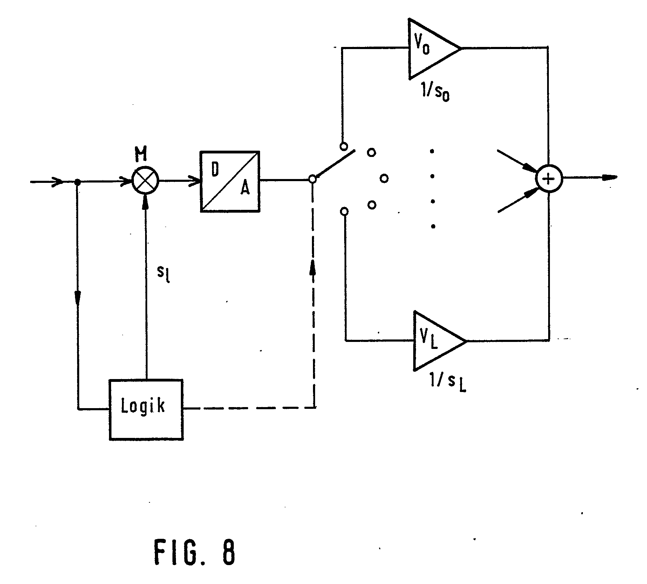

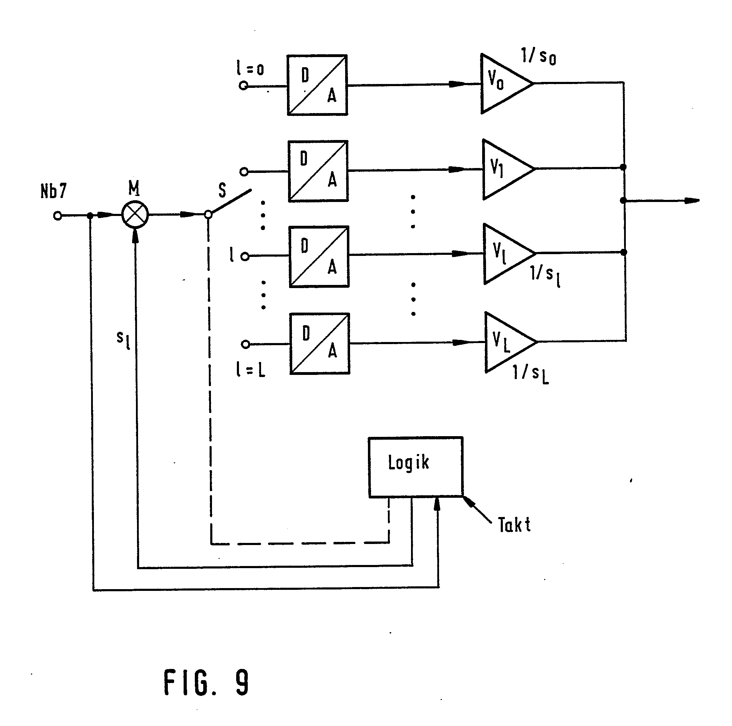

Besonders vorteilhaft ist die Anordnung gemäß Figur 8, die einen solchen D/A-Umsetzer zeigt. Die Anordnung der Figur 8 geht aus der Anordnung gemäß Figur 9 hervor, welche die Umkehrung der Figur 1 darstellt, indem lauter identische D/A-Umsetzer gewählt werden, wobei dann diese D/A-Umsetzer vor den Auswahlschalter S gezogen und ersetzt werden können durch einen einzigen D/A-Umsetzer. Der Auswahlschalter S ist dann wieder als Analogschalter zu realisieren. Generell werden aus der Auswertung des digitalen Eingangssignals jeweils der erforderliche Skalierungsfaktor $s_l$ und der zugehörige Zweig abgeleitet.

## Ansprüche

1. Verfahren zur hochauflösenden Analog/Digital-Umsetzung, bei dem dem Analog/Digital-Umsetzer ein Verstärker mit in L + 1-Stufen programmierter Verstärkung vorgeschaltet ist und dem durch Auswahl der Verstärkungsstufe das ohne Übersteuerung größtmögliche Signal zur Umsetzung zugeführt wird, dadurch gekennzeichnet,
daß das um einen bestimmten Faktor $s_l$ verstärkte Eingangssignal nach der Umsetzung in ein digitales Wort der Länge N-m mit dem Kehrwert $1/s_l$ des Faktors multipliziert wird, wobei der Kehrwert mindestens die Wortlänge m aufweist, so daß die Wortlänge des umgesetzten Signals vergrößert wird.

2. Verfahren nach Anspruch 1, dadurch gekennzeichnet, daß das digitale Wort eine Festkommazahl ist.

3. Analog/Digital-Umsetzer zur Durchführung des Verfahrens nach Anspruch 1 oder 2, dadurch gekennzeichnet,
daß $L + 1$ Verstärker ($V_0$, $V_1$, ... $V_l$, ... $V_L$) mit jeweils gleicher Verstärkung s in Kaskade geschaltet sind,
daß dem ersten Verstärker das Eingangssignal zugeführt wird, daß an jedem Verstärkerausgang ein Zweig mit einem A/D-Umsetzer angeschlossen ist,
daß ein Multiplizierer (M) und ein Auswahlschalter (S) vorgesehen sind, durch welch letzteren dem Multiplizierer das Ausgangssignal desjenigen Umsetzers zugeführt wird, der ohne Übersteuerung das größte Signal liefert, und
daß dem Multiplizierer der Kehrwert der Verstärkung der dem ausgewählten Umsetzer vorschalteten Verstärkerkette zugeführt wird (Figur 6).

4. Analog-Digital-Umsetzer zur Durchführung des Verfahrens nach Anspruch 1 oder 2, dadurch gekennzeichnet, daß $L + 1$-Verstärker ($V_0$, $V_1$, ... $V_l$, ... $V_L$) mit den Verstärkungen $s_0 < s_1 < ... < s_l < ... < s_L$ vorgesehen sind, denen jeweils das Eingangssignal zugeführt wird, daß den Verstärkern jeweils ein A/D-Umsetzer nachgeschaltet ist, daß ein Multiplizierer (M) und ein Auswahlschalter (S) vorgesehen sind, durch welch letzteren dem Multiplizierer das Ausgangssignal desjenigen Umsetzers zugeführt wird, der ohne Übersteuerung das größte Signal liefert, und
daß dem Multiplizierer der Kehrwert der Verstärkung des dem ausgewählten Umsetzer vorgeschalteten Verstärkers zugeführt wird.

5. Analog/Digital-Umsetzer nach Anspruch 3 oder 4, dadurch gekennzeichnet,
daß eine Logik vorgesehen ist, durch welche die Umsetzer auf Übersteuerung überwacht werden und durch welche die Auswahl des entsprechenden Pfades aus Verstärker- und Umsetzerkaskade durch Ansteuerung des Auswahlschalters und die Bereitstellung des entsprechenden Verstärkungskehrwertes an den Multiplizierer erfolgen.

6. Analog/Digital-Umsetzer nach Anspruch 5, dadurch gekennzeichnet, daß der Logik von den Umsetzern jeweils eine Übersteuerung anzeigendes Signal ($ü_0$, $ü_1$, ... $ü_l$, ... $ü_L$) zugeführt wird.

7. Analog/Digital-Umsetzer nach Anspruch 6, dadurch gekennzeichnet, daß der Logik die Ausgangssignale der Umsetzer zugeführt werden und daß diese mit den maximalen und minimalen auftretenden Werten verglichen werden (Figur 3).

8. Analog/Digital-Umsetzer nach einem der Ansprüche 3 bis 7, dadurch gekennzeichnet, daß zwischen Verstärker und Umsetzer jeweils ein Amplitudenbegrenzer eingefügt ist (Figur 2 bzw. 6).

9. Analog/Digital-Umsetzer nach einem der Ansprüche 3 bis 8, dadurch gekennzeichnet,
daß die Logik die die Übersteuerung anzeigenden Signale von den Amplitudenbegrenzern zugeführt bekommt.

10. Analog/Digital-Umsetzer nach einem der Ansprüche 3 bis 9, dadurch gekennzeichnet,
daß die Verstärkungen zu $s_l = 2^i \cdot 2^l$ gewählt werden mit i = beliebig konstanter ganzer Zahl.

11. Analog/Digital-Umsetzer nach einem der Ansprüche 4 bis 8, dadurch gekennzeichnet, daß den Verstärkern jeweils ein Widerstandteiler vorgeschaltet ist,
daß die Verstärker ($V_0$... $V_L$) jeweils die maximale Verstärkung $s_L$ aufweisen und
daß die Widerstandteiler einen Abschwächungsfaktor $1/s_l'$ aufweisen, so daß die Verstärkung der einzelnen Zweige $s_l = s_L/s_l'$ beträgt (Figur 4).

12. Analog/Digital-Umsetzer nach einem der Ansprüche 4 bis 8, dadurch gekennzeichnet,
daß die ausgangsseitig parallel geschalteten Verstärker ersetzt werden durch einen einzigen Verstärker mit der maximalen Verstärkung $s_L$, daß diesem Verstärker in den einzelnen Pfaden jeweils ein Widerstandteiler nachgeschaltet ist und daß die Widerstandteiler einen Abschwächungsfaktor $1/s_l'$ aufweisen, so daß die Verstärkung der einzelnen Zweige $s_l = s_L/s_l'$ beträgt (Figur 5).

13. Analog/Digital-Umsetzer nach Anspruch 8, dadurch gekennzeichnet, daß von den Amplitudenbegrenzern Übersteuerungssignale an die Logik abgegeben werden,
daß die Ausgangssignale der Amplitudenbegrenzer dem Auswahlschalter (S) zugeführt werden und
daß anstelle der $L + 1$-Umsetzer ein einziger A/D-Umsetzer vorgesehen ist, dem über den Auswahlschalter (S) das gerade noch nicht übersteuerte größtmögliche Signal zugeführt wird (Figur 7).

14. Digital/Analog-Umsetzer, gekennzeichnet durch einen A/D-Umsetzer nach einem der Ansprüche 3 bis 13, wobei alle Signalflußrichtungen und Bauelemente wie Verstärker, Begrenzer usw. umgekehrt, A/D-Umsetzer durch einen D/A-Umsetzer ersetzt und Skalierungsfaktoren jeweils durch ihre Reziprokwerte ersetzt sind.

# FIG. 1

Zweig l

$V_l$

$s_l$

Amplituden
Begrenzerschaltung
(identisch in
allen Zweigen)

A / D

$\ddot{u}_l$

Takt T

## FIG. 2

Zweig l

$V_l$

$s_l$

A / D

max

min

## FIG. 3

$\bar{u}_0$    $\bar{u}_l$    $\bar{u}_L$    S    $1/s_l$

Logik

max    min

Widerst.
Teiler

$V_l = V$

Zweig l v. FIG.1

$\frac{1}{s_l^l}$

$s_l = s = s_L$

$\frac{s}{s_l^l} = s_l$

# FIG. 4

Widerst.
Teiler

A / D

$1/s_0^l$

V

$s = s_L$

Widerst.
Teiler

A / D

$1/s_L^l$

M

$\frac{1}{s_l}$

# FIG. 5

$\overline{u}_0$

$\overline{u}_L$

Logik

FIG. 6

FIG. 7

FIG. 7a

FIG. 8

FIG. 9